# EUROPEAN PATENT APPLICATION

(11) **EP 1 251 401 A1**
(43) Date of publication of application: **23.10.2002**
(21) Application number: 01109760.7
(22) Date of filing: 20.04.2001
(51) Int. Cl.: G03F 7/20

(54) **Method of measuring the aberration of a projection lens**

(71) Applicant: Infineon Technologies SC300 GmbH & Co. KG, 01099 Dresden (DE); Infineon Technologies AG, 81669 München (DE); MOTOROLA, INC., Schaumburg, IL 60196 (US)
(72) Inventor: Ganz, Dietmar, 66806 Ensdorf (DE); Maltabes, John, Austin, Texas 78735 (US); Schedel, Thorsten, 01129 Dresden (DE)
(74) Representative: Epping Hermann & Fischer

(57) **Abstract**

A new inspection method is provided for testing lens aberrations during production of semiconductor wafers in projection apparatus such as wafer steppers or scanners. It is checked for lens degradation by measuring aberration specific measurement pattern structures (3) preferrably being arranged in fields of a test mask, and then projected to corresponding measurement pattern structures (8) on the wafer. A signal is issued, if threshold values (2) representing a corresponding aberration such as spherical aberration, astigmatism, coma or three-leaf-clover are exceeded. For the latter measurement symmetric DT-like pairs of rectangles (303) are provided in order to compare left-to-right-differences in critical dimension with threshold values (2). Also, structures combining sagittal and tangential lines into, e.g., waggon wheel-like structures (304) are provided. As a result of the signal (1) issued, a tool dedication strategy such as to reduce tool specifications can be initiated.

## Description

The present invention relates to a method of measuring the aberration of a lens of a projection apparatus, for projecting a pattern structured on a mask onto an image plane formed by a semiconductor wafer.

A projection apparatus is used for manufacturing semiconductor wafers by exposing a resist deposited on the wafer surfaces with light, that transfers the pattern of a mask or reticle through an objective lens onto the wafer surface defining the image plane. These apparatus are typically embodied as wafer steppers or wafer scanners projecting at optical or ultraviolet wavelength. Commonly, the projection is of reduction-type.

With continuously decreasing minimum structure sizes below e.g. 0.25 µm, the aim of obtaining diffraction-limited images by the projection system is aggravated by lens aberration of the objective lens. The aberration can be described by the aberration function giving for each point in the focal - or image plane respecively - plane the difference in optical path length between a light ray traversing the objective lens at a radius r and an angle θ and a light ray traversing the centre of the objective lens.

The aberration of a lens leads to a disadvantageous shift and distortion of the projected pattern structures depending on the size and direction with which they are positioned relative to each other. The aberration function can be expanded into a series of so-called Zernike-polynomials providing an orthonormal set of functions, which each represent a characteristic feature of distortion. The strength of each characteristic is given by corresponding Zernike-coefficients. The three most prominent distortion features of pattern structures on a wafer are spherical aberration, astigmatism and coma.

The spherical aberration corresponds to a Zernike-polynomial being quadratic (or of fourth order) in lens radius r. The image contrast, etch slope and pattern fidelity are disadvantageously degraded by this kind of aberration. If the numerical aperture is considerably smaller than 1, a paraxial assumption for the length projection is valid and the aberration is proportional to the defocus of the projection lens. Therefore, in case of all parts of the lens having the same effect on aberration the problem can be circumvented by readjusting the focus of the system when only quadratic terms in r are taken into account. However, this will commonly not be the case resulting in a decrease of the process window, i.e. a smaller depth of focus.

The focus shift depends on the size of the pattern that is to be transferred. It can be measured by projecting two patterns with different size and comparing the best focus determined for each of the projections. A prerequisite is, that structure sizes are small, such that each focus depth for obtaining a specified minimum image quality also covers only small intervals in order to retrieve an accurate best focus.

Astigmatism as well results in a reduction of the process window. Here, the focus shift depends on the orientation of the pattern structure transferred. While there might be a positive focus shift for e.g. a line-and-space pattern in y-direction, a negative focus shift can simultaneously emerge for the same pattern. Astigmatism can be measured by comparing the best focus determined each for vertical and horizontal lines.

The phenomenon corresponding to a third order Zernike-polynomial is coma. Image contributions from a different pupil radii of the projection lens shift relative to each other. As a consequence asymmetric pattern structures may print asymmetrically. Moreover, the transfer position in the image plane is also shifted depending on the size of the pattern structure being projected. Generally, coma is measured by using overlay tools determining the positions of multiple bar pattern structures having different structure sizes.

More recently, sophisticated methods of measuring aberration coefficients have been provided in order to check lens qualities to higher accuracy also enabling simulations of lens projections for qualifying lenses in a projection tool. For example, in JP 11-237310 a method with suitable test structures is provided for determining lens aberration. There, periodic pattern structures on a mask are projected onto a substrate with the period satisfying conditions to the wavelength, the numerical aperture and an illumination coherency factor. By varying the period, i.e. the pitch, and the size of the, e.g. lines-and-spaces pattern structure the stated aberration phenomena can be measured and the Zernike-coefficients be determined.

Nevertheless, these lens quality tests measuring shifts in the image position, image asymmetry, reduction of process windows etc. are still very time and material consuming. Once an exposure tool has been delivered by the manufacturer a lens qualification is performed during the acceptance period of the tool. Afterwards, the lens is assumed to retain its performance.

Today, lens technology approaches new dimensions. The numerical aperture is continuously increasing to values about 0.8 - 0.85, thereby causing the more critical higher order lens aberrations like three-leaf-clover aberration.

Simultaneously, specifications of critical dimension and overlay are decreasing to values less than 90 - 110 nm and 35 - 50 nm, respectively.

With the advent of the 300 mm wafer technology the lens stress is also increased due to the increasing time and number for exposures. These long-term problems cannot be considered by time consuming quality checks in the acceptance period. As a consequence a loss of yield can be expected.

It is therefore a primary objective of the present invention to improve the lens quality of a projection apparatus used in semiconductor manufacturing, thereby increasing the yield of the exposure step for semiconductor wafers.

The objective is solved by a method of measuring the aberration of a lens of a projection apparatus, for projecting a pattern structured on a mask onto an image plane formed by a semiconductor wafer, comprising the steps of providing a first mask to said projection apparatus the mask being supplied with a first pattern for structuring a layer of integrated circuit on at least one first semiconductor wafer, providing said at least one first semiconductor wafer to said projection apparatus, exposing said first wafer with said first pattern, providing a second mask to said projection apparatus the mask being supplied with at least one second pattern for structuring a measurement pattern to said projection apparatus, providing at least one second wafer to the projection apparatus, exposing said at least one second wafer with said second pattern, performing a lens aberration measurement of said second pattern, issuing a signal if said aberration measurement exceeds a threshold value, and continuing with providing a further mask and a further number of semiconductor wafers to said projection apparatus for transferring a further pattern for structuring a layer of an integrated circuit.

According to the present invention the degradation of projection lenses can be monitored periodically by simple measurements of test patterns. A threshold value is defined for the lens quality, that in case of being exceeded by a measurement generates a signal for enabling operators to undertake actions in order to maintain production quality and/or yield. A main advantage is, that short wafer printing tests are performed during manufacturing production wafers. These are represented by semiconductor wafers which are structured with layers such as to give integrated circuits when being finished after subsequently experiencing processing steps.

The first mask accordingly provides one of the layers for structuring the wafer. On the contrary the second mask comprises dedicated measurement pattern structures designed to enable an aberration measurement for the lens.

Any lens aberration phenomenon or polynomial or any other representation of aberration, e.g. Zernike-coefficients, can be measured, in particular defocus, spherical aberration, astigmatism, coma or three-leaf-clover aberration.

The measurement pattern structure can have any form, in particular periodic lines and spaces having the same or different size, concentric structures, periodic holes or symmetric structures.

The central issue of the present invention is the warning signal in response to exceeding the threshold value. It may be issued by a control unit of the exposure tool or by one of the measurement devices such as an optical microscope, a scanning electron microscope, an atomic force microscope or an overlay tool, etc. It will act as a trigger for the tool manufacturer or for the user of the tool. The user will be able to monitor the quality of the lens using the present method if a signal is issued representing a problem with the lens, i.e. degradation. The user can also react by informing the tool manufacturer to initiate countermeasurements and, if suitable, an ozone lens cleaning, or other reactions like starting tool dedication strategies.

Since the test measurement is adapted to the product, material and time for the test can be saved. In particular it is not necessary to spend large efforts on determining coefficients etc. although this is not ruled out by the present invention. Rather, it is possible to form the measurement pattern structures with respect to the product, which currently has critical requirements. E.g., critical integrated circuit structures like contact holes, deep trenches or gate lines-and-spaces of memory products can be used as measurement structures for monitoring projection lenses of exposure tools, that have to fulfil highest requirements for critical dimension and overlay, and that are used to expose semiconductor wafers for memory products.

In these cases the threshold values may e.g. be defined by left-to-right differences of symmetric structures as a representation of the three-leave-clover aberration, or by position differences measured by an overlay tool revealing the coma-effect.

In a further aspect the termination of the exposure process for manufacturing further wafers in response to said signal for performing the ozone lens cleaning step is considered. The step can advantageously be initiated automatically, while the production planning system can be informed that the current exposure tool is occupied with th maintenance step. After the cleaning is finished another signal is issued such that wafer processing can be resumed.

Additionally, the change of the tool dedication strategy after the warning signal issued can be considered. This means, that further processing of critical products is stopped in favour of other products, which do not require high specifications to overlay, critical dimension etc. This might be the case, e.g., if repeatedly ozone cleaning has been started according to the present invention, but no improvement has been recognised in the following measurement, i.e. after the number of production wafers. Then, the tool capability specifications are reduced in strictness and the production planning system cannot further send wafers according to these reduced specifications to that exposure tool. Thus, the issued signal is evaluated by the production planning system (CIM) according to this aspect. Preferably, a lens quality measurement history is available to the production planning system, or the exposure tool control unit.

In a further aspect the measurement of the lens aberration comprises at least one of a position measurement in x- or y-direction, i.e. with an overlay tool, a critical dimension measurement in x- or y-direction, or a pitch measurement in x- or y-direction. Both optical or scanning electron microscopes or at least one of them can be used to perform these measurements.

In a further aspect the measurement pattern structure is considered to comprise concentric sagittal or tangential line structures, which are preferably arranged periodically. These are provided for measuring astigmatism. A typical example is a waggon wheel with the spokes and rims formed out of lines. If the circle shaped patterns (rims) and the radio patterns (spokes) have different focal planes the different effects of astigmatism affect different features of e.g. the wheel. This can be analysed by pattern recognition software.

In a further aspect the measurement pattern structure is considered to comprise symmetric structures such as e.g. pairs of deep trench rectangles in order to clarify coma - or three-leaf-clover effects. This is evident, if the printed structure of the symmetric pattern reveals asymmetry. Especially due to using litho enhancement techniques- in particular phase shift masks - the latter aberration type can become a prominent feature by building artefacts around the structure building up asymmetry. This aspect of the present method thus advantageously increases the wafer yield during exposure particularly in the case of phase shift masks, but is also applicable to conventional masks like chrome-on-glass or chromeless masks. The symmetric pattern structure according to the present invention preferrably comprises an arrangement of pairs of patterns, particularly rectangles, which can be compared to each other before printing, i.e. on the mask, where they are formed e.g. having the same size, and after the printing, i.e. on the wafer, where they might have altered, different size due to aberraton effects. The patterns of a pair may also be connected with each other, as e.g. in a U-shaped form.

In a further aspect the measurement structure is considered to be at least one of lines-and-spaces or contact holes.

In a further aspect the aberration measurement is performed by first measuring the asymmetry of a pattern structure transferred through the projection lens from a symmetric pattern on the mask, the amount of asymmetry then being compared with a threshold value. If the threshold value is exceeded by the measured asymmetry further structures of the measurement pattern such as lines-and-spaces or contact holes are measured for aberration. Else, further processing of production wafers is continued. In the latter case a signal is issued if these additional measurements reveal problems with lens aberration.

Further advantages and aspects are evident from the dependent claims.

The invention will be a better understood by reference to the following description of embodiments of the invention taken in conjunction with the accompanying drawings, wherein
- figure 1: shows a flow chart of an embodiment according to the present invention,
- figure 2: shows a measurement pattern structure comprising contact holes,
- figure 3: shows a measurement pattern structure according to the present invention comprising symmetric structures,
- figure 4: shows a measurement pattern structure comprising vertical and horizontal lines and spaces,
- figure 5: shows a measurement pattern structure according to an embodiment of the present invention comprising sagittal and tangential structures,
- figure 6: shows a measurement pattern structure according to an embodiment comprising an arrangement of different pattern structures.

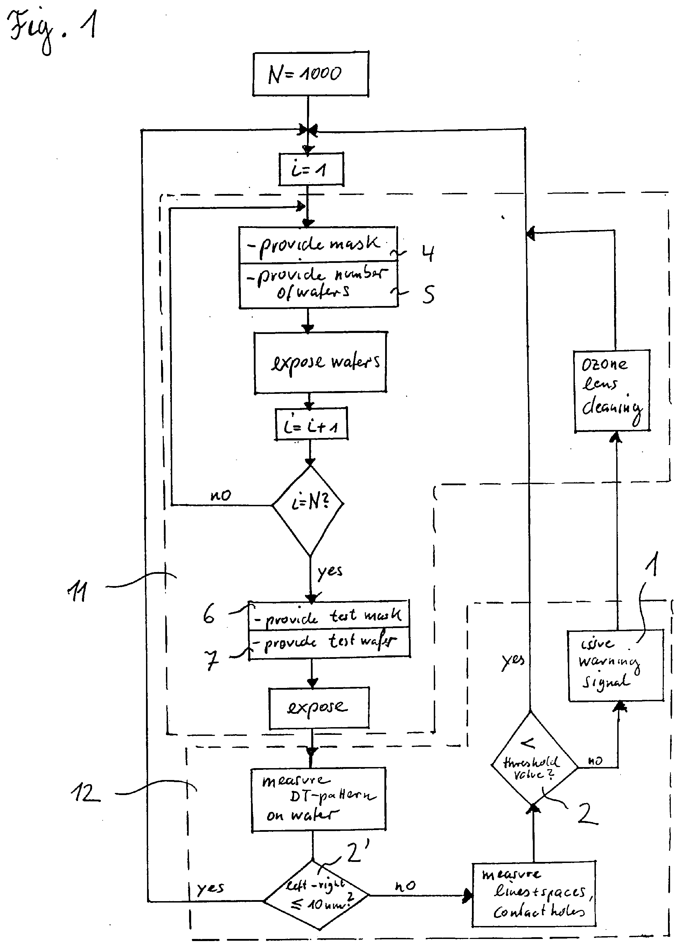

A flow chart of the steps of an embodiment according to the present invention is shown in figure 1. The tools involved are the projection apparatus 11 and a set of metrology tools 12. According to this embodiment the aberration measurement is performed every 100 mask supplies to the projection apparatus. The control unit of the exposure tool counts the masks, and the wafers, provided to the projection apparatus and checks, whether the number of 100 masks has been reached. The number of wafers exposed per mask is typically considerably larger than 1. The masks, or reticles respectively, comprise a pattern, that is suitable to build a layer on the wafer substrate when being transferred to the wafer via a projection lens in order to generate an integrated circuit. In particular these are production wafers 5.

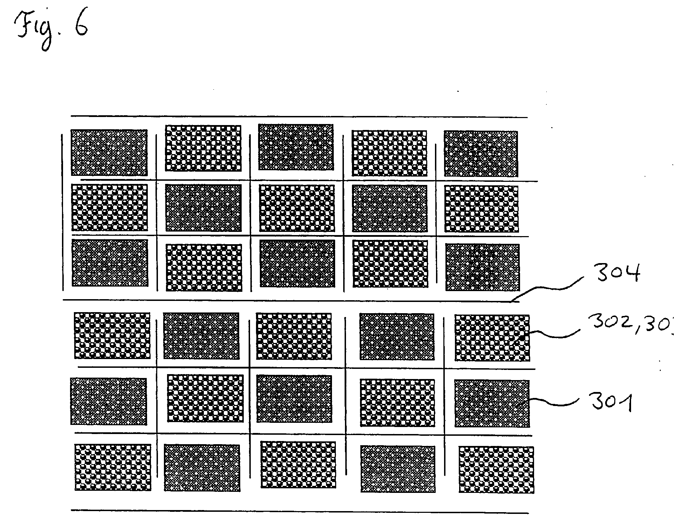

If the number of 100 of provided production masks 4 is reached, a mask 6 comprising a measurement pattern structure 3 is provided to the projection apparatus 11 for transferring the structure to a test wafer 7. The measurement pattern structure 3 consists of several substructures being arranged in an array as shown in figure 6. The array according to this embodiment is a field with a length of 33 mm and a width of 26 mm. It comprises subarrays of measurement structures being lines-and-spaces 301, contact holes 302, symmetric deep-trench-(DT)-like structures 303 and wagon wheels 304 being arranged in lines.

By exposure these measurement pattern structures 3 on the mask are transferred to form measurement pattern structures 8 on the test wafer 7.

The aberration measurement step performed in this embodiment is essentially a 2-step procedure. Since high-end phase shift masks and correspondingly high-end exposure tools are maintained by this method, the three-leaf-clover aberration is measured first. Of the DT-like pairs of originally symmetric rectangles 303 on the mask the left-to-right differences of the images of the wafer, i.e. the measurement pattern structures 8, are measured using and scanning electron microscope.

A threshold value 2' of 10 nm is compared to the measurement result. If the measured left-to-right difference is smaller than this threshold value 2' further exposure of production wafers 5 with production masks 4 is resumed.

If on the other hand the threshold value 2' is exceeded by the measurement result of the DT-like pattern structure 303 on the wafer, further measurement pattern structures 8 on the wafer like lines-and-spaces 301, contact holes 302 and waggon wheels 304 each being supplied with additional threshold values 2 to which the measured results are compared, are to be measured. Depending on the result of the comparison further wafer production is resumed.

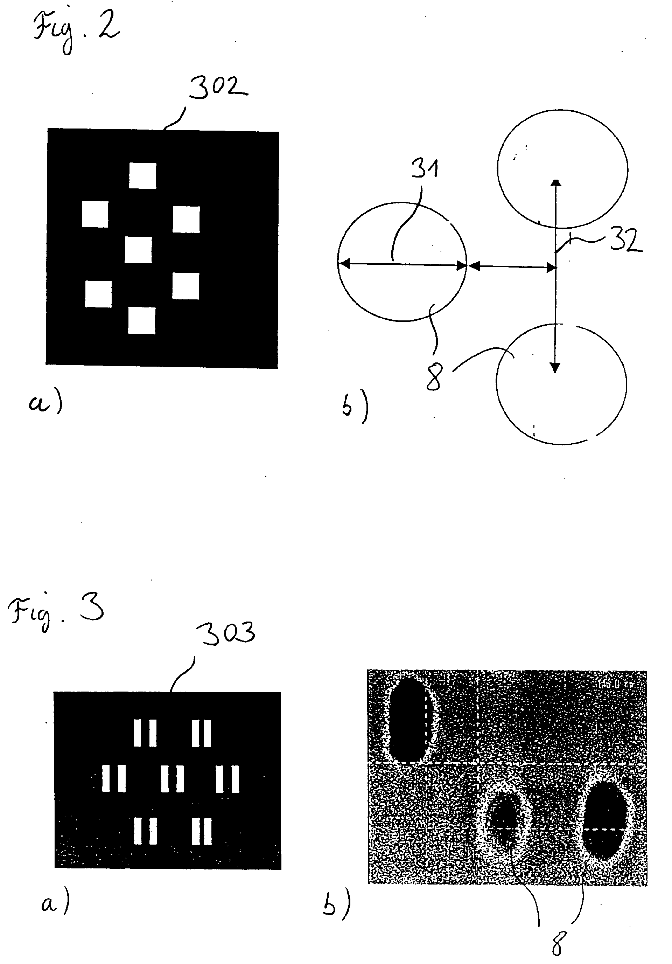

An example of a measurement pattern structure 3 comprising contact holes 302 on a mask is shown in figure 2a. Figure 2b displays the features to be measured on the wafer, e.g. the critical dimension 31, the pitch 32 in x- and y-direction of the transferred measurement pattern structures 8. An example of the symmetric DT-like structures 303 on a mask are shown in figure 3. The corresponding image on a wafer, i.e. the measurement pattern structure 8 being asymmetric due to three-leave-clover aberration is shown in figure 3b.

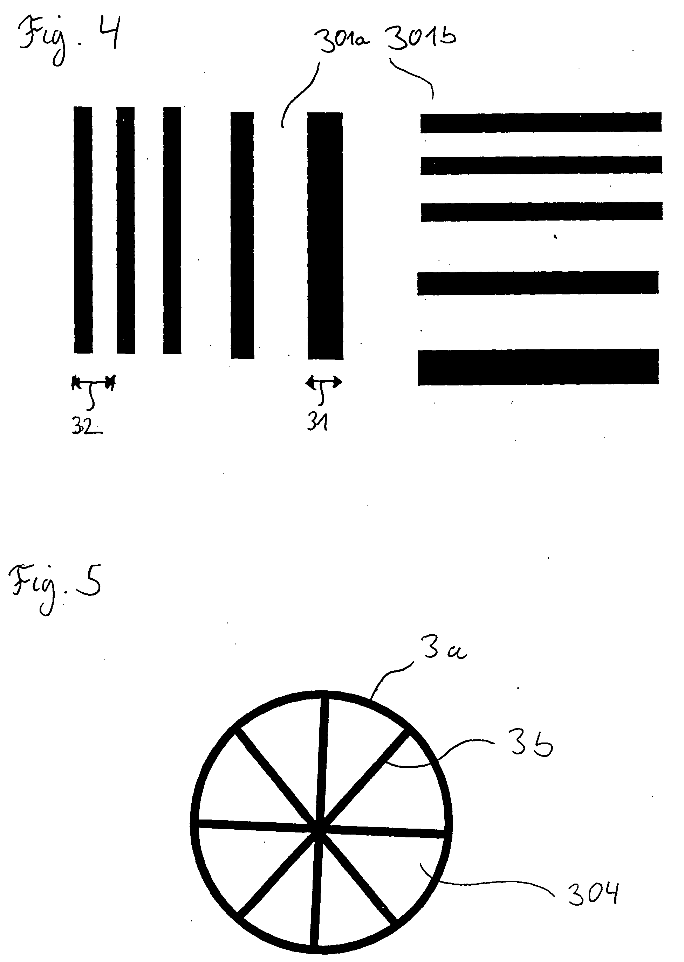

A representative example of the lines-and-spaces structure 301 is shown in figure 4. Vertical lines and spaces 301a and horizontal lines and spaces 301b are formed into the measurement pattern structure 3 on the mask in order to enable an astigmatism aberration measurement of the transferred measurement pattern structure 8 on the wafer.

The measurements using a scanning electron microscope according to the present invention are combined with an optical inspection via a wagon wheel 304 being arranged along lines as shown in figure 6. Wagon wheel test patterns 304 may be used for automatic optical inspection tools. The lens aberrations can be discovered with the help of pattern recognition software. The size of the radial lines 3b and circle 3a, the number of circles and lines are variable and can be adjusted to technical requirements. A test pattern is printed on the wafer in best focus or by stepping through the focus. In case of lens aberrations the pattern is distorted due to the astigmatism aberration effect, circle shaped patterns 3a and radial patterns 3b have different focal planes and therefore are distorted differently. The inspection tools compare the actual lens status with a reference pattern of a good quality.

If due to one of the measurement pattern structures 8 on the wafer the measurement of an aberration reveals a characteristic quantity being larger than the threshold value specified, warning signals issued signalling the problems with the lens are issued. The signal is sent from the metrology tool 12 back to the exposure tool 11, where an ozone lens cleaning step is initiated. After this cleaning step further exposure of production wafers 5 with production masks 4 is resumed.

Instead of performing an ozone lens cleaning, an exchange of lenses may alternatively be initiated according to this embodiment.

### List of numerals

| | |
|---|---|
| 1 | warning signal |
| 2 | threshold value |
| 3 | measurement pattern structure, on mask |
| 4 | mask, for production |
| 5 | semiconductor wafer, for production |
| 6 | mask, for measurement |
| 7 | semiconductor wafer, for measurement |
| 8 | measurement pattern structure, on wafer |
| 11 | projection apparatus |
| 12 | metrology tool: SEM or optical microscope |
| 31 | critical dimension |
| 32 | pitch |
| 301 | lines and spaces |
| 302 | contact holes, squares |
| 303 | pairs of structures being symmetric about an axis, pairs of deep-trench-like rectangles |
| 304 | waggon wheel, tangential and sagittal lines |

## Claims

1. Method of measuring the aberration of a lens of a projection apparatus, the apparatus being designed to project a pattern structured on a mask onto an image plane formed by a semiconductor wafer, comprising:
- providing a first mask to said projection apparatus the mask being provided with a first pattern for structuring a layer of an integrated circuit,
- providing at least one first wafer to said projection apparatus,
- exposing said at least one first wafer with said pattern,
- providing a second mask to said projection apparatus the mask being supplied with at least a second pattern (3),
- providing at least one second wafer,
- exposing said at least one second wafer with said second mask,
- performing a lens aberration measurement in dependence of at least one measurement pattern structure (8), which is structured on the wafer from said second pattern (3),
- issuing a signal (1) in response to the measured aberration,
- providing a further mask and a further semiconductor wafer for transferring a further pattern for structuring a layer of an integrated circuit, depending on said signal (1).

2. Method according to claim 1,
**characterized by**
issuing said signal (1), if said measured aberration exceeds a threshold value (2).

3. Method according claims 1 or 2,
**characterized by**
terminating the exposure of further wafers in response to said signal (1) for performing a lens cleaning step.

4. Method according to anyone of claims 2 to 3,
**characterized in that**
said aberration measurement comprises at least one of
- a position measurement,
- a critical dimension (31) measurement, or
- a pitch (23) measurement.

5. Method according to anyone of claims 2 to 4,
**characterized in that**
said measurement pattern structure (3) comprises each at least one sagittal measurement pattern (3b) and tangential measurement pattern (3a) for measuring astigmatism.

6. Method according to anyone of claims 2 to 5,
**characterized in that**
said measurement pattern structure (3) comprises an arrangement of at least two patterns (303), in particular rectangles, which are symmetric about one axis.

7. Method according to anyone of claims 2 to 6,
**characterized in that**
said measurement pattern structure (3) comprises at least one of lines and spaces (301) and contact holes (302).

8. Method according to anyone of claims 2 to 7,
**characterized in that**
said aberration measurement comprises the steps of
- first measuring the transferred structure of an arrangement of at least two patterns (303), which are symmetric about one axis, of the at least one measurement pattern structure (8),
- comparing the measured value with a threshold value (2),
- measuring the lens aberration of at least one measurement pattern structures (8) on the wafer, which is different from said first measured pattern, if said measured aberration exceeds the threshold value.
